# EUROPEAN PATENT SPECIFICATION

(11) **EP 1 485 959 B1**
(45) Date of publication and mention of the grant of the patent: **02.12.2009**
(21) Application number: 03708374.8
(22) Date of filing: 12.03.2003
(51) Int. Cl.: H01L 51/52

(54) **OPTICAL LIGHTING DEVICE AND METHOD TO PRODUCE LIGHTING DEVICES ADOPTING SAID OPTICAL DEVICE**
OPTISCHE LEUCHTANORDNUNG UND VERFAHREN ZUR HERSTELLUNG LEUCHTANORDNUNGEN MIT SOLCHEN OPTISCHEN VORRICHTUNGEN
DISPOSITIF D'ECLAIRAGE OPTIQUE ET PROCEDE DE PRODUCTION DE DISPOSITIFS D'ECLAIRAGE UTILISANT UN TEL DISPOSITIF D'ECLAIRAGE OPTIQUE

(30) Priority: 12.03.2002 IT UD20020059 U
(43) Date of publication of application: 15.12.2004
(73) Proprietor: Automotive Lighting Rear Lamps Italia S.p.A., 10078 Venaria Reale (TO) (IT)
(72) Inventor: MELPIGNANO, Patrizia, I-33010 TAVAGNACCO (IT); ZAMBONI, Roberto, I-40100 BOLOGNA (IT)
(74) Representative: Petraz, Gilberto Luigi
(86) International application number: PCT/IB2003/000895
(87) International publication number: WO 2003/077325

(56) References cited:
- EP-A- 0 509 630
- US-A1- 2001 033 135
- US-A1- 2002 141 006
- MADIGAN C F ET AL: "IMPROVEMENT OF OUTPUT COUPLING EFFICIENCY OF ORGANIC LIGHT-EMITTINGBY BACKSIDE SUBSTRATE MODIFICATION" APPLIED PHYSICS LETTERS, AMERICAN INSTITUTE OF PHYSICS. NEW YORK, US, vol. 76, no. 13, 27 March 2000 (2000-03-27), pages 1650-1652, XP000950541 ISSN: 0003-6951
- PATENT ABSTRACTS OF JAPAN vol. 1998, no. 13, 30 November 1998 (1998-11-30) -& JP 10 223367 A (MITSUBISHI CHEM CORP), 21 August 1998 (1998-08-21)
- PATENT ABSTRACTS OF JAPAN vol. 1997, no. 07, 31 July 1997 (1997-07-31) -& JP 09 076245 A (NIPPON COLUMBIA CO LTD), 25 March 1997 (1997-03-25)
- PAN L-W ET AL: "Cylindrical plastic lens array fabricated by a micro intrusion process" MICRO ELECTRO MECHANICAL SYSTEMS, 1999. MEMS '99. TWELFTH IEEE INTERNATIONAL CONFERENCE ON ORLANDO, FL, USA 17-21 JAN. 1999, PISCATAWAY, NJ, USA,IEEE, US, 17 January 1999 (1999-01-17), pages 217-221, XP010321678 ISBN: 0-7803-5194-0
- PATENT ABSTRACTS OF JAPAN vol. 2000, no. 06, 22 September 2000 (2000-09-22) & JP 2000 077188 A (CANON INC), 14 March 2000 (2000-03-14) -& US 2002/135664 A1 (SEIJI MASHIMO ET AL) 26 September 2002 (2002-09-26)
- PATENT ABSTRACTS OF JAPAN vol. 2000, no. 09, 13 October 2000 (2000-10-13) -& JP 2000 155201 A (OMRON CORP), 6 June 2000 (2000-06-06)

## Description

### FIELD OF THE INVENTION

The present invention concerns an optical lighting device, used to make integrated electro-optical lighting devices of the multi-layer type.

Such integrated lighting devices comprise at least an outer substrate to irradiate and diffuse the light, at least partly transparent and advantageously of the flexible type, on one face of which an electro-luminescent light source is integrally made, comprising light emitting means of the organic led type (organic light emitting diode, hereafter OLED).

The present invention is characterized in that a lenticular optical micro-element to diffuse the light is made directly and integrally by means of molding on the other face of the flexible and transparent substrate, so as to constitute, with said organic led-type light source, an integrated multi-layer structure as a source/diffuser of light, suitable to achieve particular and desired effects for the emission and direction of the light beams.

The invention also concerns the method to produce integrated lighting devices adopting said optical device.

### BACKGROUND OF THE INVENTION

In the field of production of electric and electronic instruments and apparatuses, it is known to use light emitting devices which comprise led-type electro-luminescent light sources used to make lighting devices, displays, or more generally illuminated display screens.

As is known, leds are devices able to convert electric energy into luminous energy and are therefore able to emit radiant energy in the form of light when they are fed by a suitable electric current.

Applications of this type of light sources are extremely various and can comprise displays or monitors for calculators, screens for portable or fixed telephone systems, screens for televisions or measuring instruments/indicators, luminous panels, inside lights for rooms, lighting devices in general and other uses.

In the field of automobile or motor vehicle production, both for the instruments on the dashboard inside and for part of the lighting system, this type of led-type light source has sometimes replaced conventional incandescent bulbs, thanks to the particular and appreciated aesthetic effects of multi-point emission which can be obtained.

Leds using conventional semi-conductors have recently been supported and/or replaced by leds which use organic-type film (OLED) obtained with particular compounds which, from the point of view of electric conduction, have characteristics comparable to those of semi-conductors. The possibility of using synthetic organic compounds as a luminescent element has allowed to make lighting devices and displays of smaller size and high resolution, at the same time ensuring high efficiency in the transmission of light, and long duration.

A typical multi-layer light source with leds of this type comprises a negative pole (cathode), possibly made with an alloy of aluminum and indium, at least a luminescent layer made of organic material which also encourages the passage of the charge between the electrodes, a positive pole (anode) normally consisting of a transparent conductive electrode and a transparent substrate to emit the light. Said substrate is advantageously of the flexible type and can be made of glass or transparent plastic.

Between the anode and the transparent substrate there is advantageously a protective layer to prevent infiltrations of air and water in contact with the organic films and the electrodes.

Document JP-A-10-223367 provides a method to produce optical systems by means of the photo-curing system, possibly also by means of exposure through a mask; this method does not allow to obtain the micro-optical systems in a repeatable and industrial manner with the prescribed values of size, since such photo-curing system is a laboratory technique, embodied in an experimental method which is not applicable for serial production.

This document does not teach to make the organic led light source directly on the transparent substrate, since the layers that form the light source (anode, cathode and luminescent layer), are laminated onto the substrate and not made to grow directly thereon.

Moreover, this document provides that the optical systems are produced on a plastic film that is then applied separately to an organic led device (OLED) produced on glass. This method not only increases costs, but also does not guarantee a constant precise positioning of the optical system with respect to the light source.

Document JP-A-09-171892 emphasizes the fact that it uses optical systems essentially of the spherical type coupled with OLED structures.

The optical systems described are all of the refractive type, and in particular are of the type with a refractive distributed index. The Applicant has discovered, on the contrary, that better results, in relation to the aims proposed, are obtained with optical systems of a diffractive type. In addition, said document emphasizes the importance of centering the lenses on the emittent pixels, whereas the Applicant has discovered that better results, in terms of directing and shaping the beam, are obtained by shifting the centering between the emittent pixel and the micro-optical system, in order to obtain the effect of directing the light in the most convenient and suitable manner to obtain a desired distribution of radiation output from the integrated device.

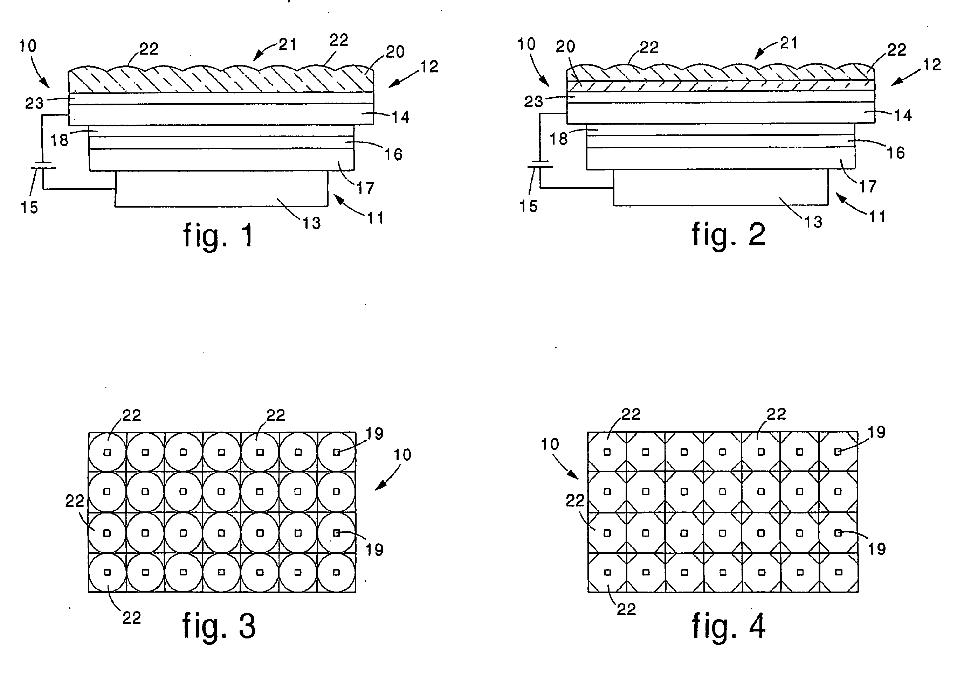

In general, it must be underlined that the prior art proposes solutions wherein the optical system is applied on the emittent substrate containing the light sources in order to increase the efficiency of light emission, that is, to increase the percentage of luminous radiation emitted from the front of the device with respect to that which is lost at the sides (see for example also JP-A-04-192290 and JP-A-2001-135477). It is known, in fact, that due to the variation in the index of refraction in the glass/air or plastic/air interface, a mirror effect is determined inside the optical device due to the total reflection of the radiation emitted, so that a high percentage of luminous radiation remains trapped in a sort of wave guide, and consequently the frontal emission is reduced. The presence of a corrugated optical system applied to the emittent face of the substrate, varying the angle of incidence of the incident ray, encourages a better extraction of the light beam from the front zone with fewer losses due to the entrapment of the light because of the wave guide effect. A teaching in this direction also comes from the article "Improvement of output coupling efficiency..." by C.F. Madigan et al., Applied Physics Letters, 76(13), 1650-1652 which teaches precisely to apply, by means of lamination, as shown in fig. 3, a lenticular optical system on an organic substrate of light emission in order to vary the angle of incidence of the ray of light and thus increase the efficiency of emission of the optical device. This document teaches to make a thin layer of transparent micro-lenses in a printed silicon sheet and then laminate it on the glass substrate after the organic leds have been applied.

However, the state of the art does not deal with the problem of directing and shaping the light beam, using said micro-lenses. The application techniques of the micro-lenses, which use applied layers like JP' 528, or laminated, as in the article by Madigan et al., which are therefore micro-lenses that are not made directly on the substrate, teach away from the purpose of directing the light beam according to desired angles, since such techniques do not allow to guarantee a micrometric positioning of the individual lens with respect to the relative light source. Nor do such techniques allow to guarantee a precise diversification of the orientation and shaping of the light beam inside the same optical device.

For the same reason, US-A-6,080,030 does not achieve the purpose set since the lenses are obtained either by applying a layer of ultraviolet cured resin on an emittent substrate, or by implanting ions in the substrate in order to produce a distribution of the refractivity. However, this solution is intended to obtain an image with very pure colors, since every color is refracted in a differentiated manner inside the individual lens, but it does not allow to obtain a desired orientation of the light beam emitted.

US 2002/0141006 does not concern organic led light sources, since it uses conventional leds of an electronic type with a semi-conductor. Such electronic leds, as such, cannot be made directly on the substrate but must necessarily be applied thereto as a distinct element.

Therefore, such conventional light sources, from the point of view of diffusing the light beams produced by the led-type sources, do not have characteristics such as will allow both to achieve appreciable aesthetic effects, and to make said beams able to be oriented and directed so as to cover areas which cannot be reached without using particular optical effects.

JP-A-09-076245, PAN L-W ET AL "Cylindrical plastic lens array fabricated by a micro intrusion process", and EP-A-0.509.630 disclose a method to obtain lighting devices, which employ micro-lenses.

The Applicant has devised and embodied the present invention to overcome these shortcomings of the state of the art and to obtain further advantages.

### SUMMARY OF THE INVENTION .

The present invention is set forth and characterized essentially in the respective main claims, while the dependent claims describe other innovative characteristics of the invention.

The purpose of the present invention is to achieve light sources to make lighting devices using radiant electro-luminescent devices able to emit and diffuse light beams suitably directed and directable when fed by a suitable electric impulse.

Another purpose is to perfect a method to produce lighting devices which allows to make multi-layer integrated lighting structures using organic led technology.

The invention can advantageously be used to make lighting instruments in the field of automobiles, both for the lighting system and for the instrument panel inside, although this application is not to be considered in any way restrictive.

In accordance with these purposes, a lighting device according to the present invention comprises a light source consisting of an integrated multi-layer structure with a transparent substrate on one face of which at least a positive and negative electrode to supply electric power are integrally made, between which at least an organic luminescent layer is located, so as to constitute a so-called organic led (OLED).

The substrate is at least partly transparent and is able to diffuse, in a diffractive manner, the light generated by the luminescent layer.

According to a distinctive characteristic of the present invention, a lenticular optical element to diffuse the light beam is made by means of molding on the opposite face of said substrate, with respect to the face where there is the organic led light source, so as to constitute, with said organic led light source, a completely integrated structure to generate, emit and direct the light.

The lenticular optical element consists of a plurality of micro-lenses made directly on said plastic substrate, in a position and number mating with the position of the crossing points between anode and cathode of the light source, so that every lens constitutes an element for the calculated diffusion of the light emitted by each individual light source point.

According to the invention, the lenticular optical element is made directly, by means of a pre-formed mold, on the outer face of the transparent substrate. This embodiment allows to configure the mold so as to obtain, with micrometric precision, the desired effect of directing and shaping the light beam, even lens by lens or zone by zone of the optical device.

The Applicant has verified that, according to a characterizing feature according to claim 1 of the invention, a desired effect of shaping the beam is obtained by shifting, for example by some microns, the center, or baricenter in the case of a non-spherical shape, of the lens from the center of the relative pixel which emits the light.

The Applicant has also found that, although in general the state of the art teaches to use optical systems of a refractive type since the objective is to increase radiant efficiency, in order to achieve the purpose set it is preferential to use an optical system of a diffractive type.

An optical system of a diffractive type does not compromise the efficiency of the light radiation but allows to obtain the desired characteristics of orienting and directing the light beams according to the desired design specifications.

In one embodiment of the invention, the micro-lenses which constitute the optical element are all alike; according to another solution, the lenses are differentiated according to the zones of the optical element, or even lens by lens, so as to create a desired differentiated effect in the directioning of the individual rays of light according to the design specifications.

In a first embodiment, the molding of the lenticular optical element on a face of the substrate is performed cold whereas, according to a preferential variant, the molding is performed hot.

Obtaining the micro-lenses directly on the plastic substrate by means of molding, and in particular obtaining the micro-optical systems by means of the hot-embossing technique, allows to achieve large quantities of plastic supports industrially and in a repetitive manner, already equipped with the desired micro-optical systems. This would not be possible using the laboratory techniques proposed in the state of the art.

The Applicant has found that this embodiment becomes advantageous using molds having at least the operative layer made of nickel, wherein the impressions to define the optical matrixes, all the same or different from each other, are obtained with the known procedure called "step and repeat".

In one embodiment of the invention, the molding of the lenticular optical element can be performed either before or after the layers, which make up the light source emitting the light, have already been made to grow on the opposite face of the transparent substrate.

In a preferential embodiment, the lenticular optical element is made of transparent plastic material, with high thermo-forming characteristics.

In a further preferential embodiment, the lenticular optical element has a thickness of between 1 and 100 µm (micron), advantageously between 1 and 40 µm, and a lateral size of between 5 and 1000 µm, advantageously between 10 and 300 µm.

### BRIEF DESCRIPTION OF THE DRAWINGS

These and other characteristics of the present invention will be apparent from the following description of a preferential form of embodiment, given as a non-restrictive example, with reference to the attached drawings wherein:
- fig. 1 shows, in section, a first form of embodiment of a lighting device according to the present invention;
- fig. 2 shows, in section, a second form of embodiment of the device according to the invention;
- figs. 3, 4 and 5 show, from above, in three possible variant solutions, a lighting device according to the invention;
- fig. 6 shows a detail of fig. 5 on enlarged scale.

### DETAILED DESCRIPTION OF SOME PREFERENTIAL FORMS OF EMBODIMENT OF THE INVENTION

With reference to the attached figures, a lighting device, of the type using organic led technology to generate light, is denoted in its entirety by the reference number 10.

The device 10 according to the invention consists of a multi-layer structure comprising, in a completely integrated form, a multi-point organic led-type light source (OLED), denoted in its entirety by the reference number 11, and an optical system to diffuse and direct the light beams, denoted in its entirety by the reference number 12.

The light source 11 consists of a negative electrode, or cathode, 13 and of a positive electrode, or anode, 14, connected to each other by a circuit comprising an electric feed source 15. Feed can be either in alternating current or direct current.

The cathode 13 can consist, for example, of a metallic film made of aluminum-indium alloy. The anode 14 is advantageously made of transparent metal and can consist, for example, of an indium-tin oxide.

In an intermediate position between the cathode 13 and the anode 14 there is a luminescent multi-layer structure formed, in this case, by two layers 16 and 17 of thin-film semi-conductors, one p-type and one n-type, which constitute the active element of the light source.

In one embodiment, the semi-conductor films consist of at least a p-type organic compound, for example naphtha-phenylene benzidine (NPB), and at least an n-type organic compound, for example aluminum hydroxyquinoline (Alq). These specific compounds are cited here only as an example, and are not to be considered in any way restrictive for the possible applications of the present invention.

The use of organic compounds to make semi-conductor light sources is in itself known, and, compared with traditional semi-conductors, allows to increase the efficiency and duration of said sources, also allowing to make lighting devices, displays and screens of extremely limited thickness and with a high capacity to transmit light.

Between the anode 14 and the upper semi-conductor layer 16 there is, in this case, a stabilizing layer 18, made, for example, of copper phtalocyanine. The anode 14, the cathode 13 and the semi-conductor layers 16 form a matrix whose crossing points, indicated by the reference number 19 in figs. 3-5, define the individual points of light emission of the optical lighting device 10.

Particularly in the case when semi-conductors of an organic type are used, between the anode 14 and the transparent substrate 20 there is advantageously a thin protective layer 23 to protect against infiltrations of water, oxygen and other degrading elements.

All this as described heretofore is substantially known in the art for the production of displays and lighting screens.

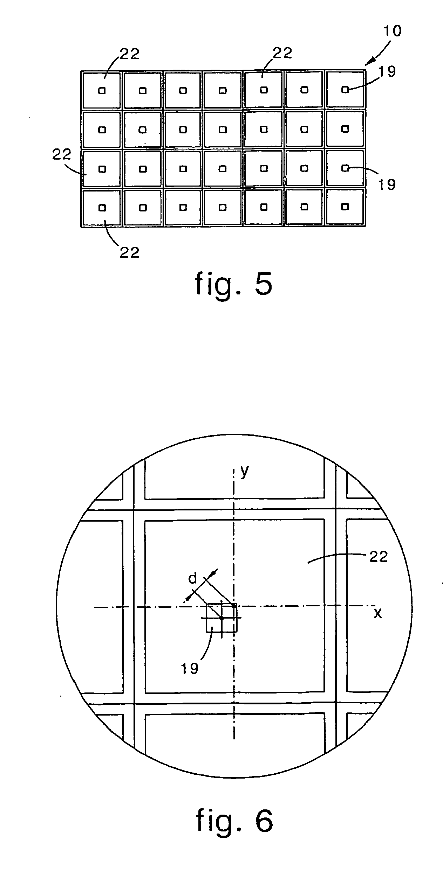

The optical system to diffuse and direct the light 12, in this case, comprises a transparent substrate 20 of a substantially conventional type, made of plastic or other transparent material, and preferentially of the flexible type, on one face of which is directly made a lenticular element 21 comprising a plurality of micro-lenses 22 cooperating with the multi-point organic led-type light source. Said micro-lenses are obtained by means of molding directly in the substrate. To be more exact, each micro-lens 22 is centered and oriented so as to be displaced (fig. 6) by a distance "d" of some microns, or tenths of microns, with respect to the relative light source consisting of a relative crossing point 19 or pixel, so as to create a plurality of light emission points focused in a desired manner by means of the specific design of the lenticular element 21. To be more exact, this shifting of the center of the micro-lens 22 can occur both along one of the two main axes, x or y, of the micro-lens 22, and also with respect to both, so that the distance "d" is defined by components dₓ and d_{y}.

According to the application and the type of light source, the micro-lenses 22 can be of the refractive or diffractive type, but preferentially they are of the diffractive type, since this type of lenses, while it does not reduce the efficiency of the radiation emitted, allows better results in terms of directing the light beam, which can thus be made coherent with the design specifications, even lens by lens.

As can be seen in the embodiment shown in fig. 1, the lenses 22 are made directly on the transparent substrate 20, for example by means of molding, either cold or hot, of its outer surface by means of a suitable pre-formed mold. The preferential embodiment, which as we have said uses a hot-embossing technique to make the lenses directly on the substrate, allows to achieve, on an industrial scale, large quantities of micro-optical systems characterized by micrometric precision both with regard to the positioning with respect to the relative light sources and also with regard to the geometry of the corrugations proposed for shaping the beam. The use of molds made of nickel, whose impressions are conformed according to design specifications, constitutes a peculiarity of the present invention which achieves considerable advantages in that it saves time and money, the material is easier to find, and results are standardized.

Therefore, although in the state of the art it is known to make the micro-optical system by molding directly onto a face of a transparent substrate, it is not known to make said micro-optical system on a substrate on whose opposite face an organic led light source is directly generated.

Said molding is advantageously performed before the light source 11 is associated on the other face of the substrate 20. According to a variant, the lenses 22 are molded on the outer face of the substrate 20 after the light source has already been associated with the other face of the substrate 20.

By obtaining the lenticular element 21 by means of molding onto one face of the transparent substrate 20, we in fact achieve an integrated micro-optical system to diffuse the light beams, suitable to create particular effects, both aesthetically and in directing the light beam, with a distribution of the light intensity which cannot be achieved with luminous devices used at present.

According to the use and aesthetic effect to be obtained, the lenses 22 can be substantially of any shape, for example circular (fig. 3), hexagonal (fig. 4), square (fig. 5), or any other shape, provided they are suitable to be positioned in a desired manner in correspondence with the crossing points 19, or pixels, advantageously with a desired shift "d", corresponding to the individual light sources.

## Claims

1. Lighting device comprising an at least partly transparent substrate (20), and a light source (11) made integrally on a first face of said substrate (20), said light source (11) including at least a positive electrode (14) and a negative electrode (13) to supply electric power, interacting with each other and between which at least a luminescent layer of the organic led type (OLED) (16, 17) is located, said substrate (20) being able to diffuse the light generated by said organic led luminescent layer (16, 17), a lenticular optical element (21) being associated on the opposite face of said substrate (20), said lenticular optical element (21) being able to diffuse the light beam emitted by said light source (11) comprising a plurality of micro-lenses (22) directly molded, by means of a pre-formed mold, on a second face of said substrate (20) opposite to the first face so as to constitute, with said organic led light source (11), an integrated structure to generate, emit and direct the light, each one of said micro-lenses (22) being coupled with a relative point of light emission (19) of said light source (11) to direct and shape the relative light beam emitted, **characterized in that** said micro-lenses (22) have the relative center located shifted with respect to the relative point of light emission (19).

2. Device as in claim 1, **characterized in that** each of said points of light emission (19) consists of crossing points (19), or pixels, between said positive electrode (14) and said negative electrode (13).

3. Device as in claim 1, **characterized in that** said shift is achieved with respect to one and/or the other of the main axes (x, y) of the relative micro-lens (22).

4. Device as in any claim hereinbefore, **characterized in that** at least some of said micro-lenses (22) are of the diffractive type in order to divert and direct the ray of light emitted by the relative point of light emission (19).

5. Device as in any claim hereinbefore, **characterized in that** said micro-lenses (22) have a thickness of between 1 and 100 micron (µm), preferably between 1 and 40 micron.

6. Device as in any claim hereinbefore, **characterized in that** said micro-lenses (22) have a lateral size of between 5 and 1000 micron, preferably between 10 and 300 micron.

7. Device as in any claim hereinbefore, **characterized in that** the micro-lenses (22) of a relative lenticular optical element (21) are all equal to each other.

8. Device as in any claim from 1 to 6 inclusive, **characterized in that** the micro-lenses (22) of a relative lenticular optical element (21) are different from each other in order to direct and shape the light beam emitted by the relative point of light emission (19).

9. Device as in any claim from 1 to 8 inclusive, **characterized in that** said substrate (20) is made of plastic material.

10. Device as in any claim from 1 to 8 inclusive, **characterized in that** said substrate (20) is made of at least partly flexible glass.

11. Method to produce lighting devices comprising at least an organic led-type multi-layer light source (11) and at least an optical system (12) to diffuse and direct the light beams, comprising at least an at least partly transparent substrate (20), at least a lenticular optical element (21) being associated with one face of said substrate (20) opposite to the face where said light source (11) is provided, **characterized in that** said lenticular optical element (21) is directly molded, by means a pre-formed mold, on said substrate (20) to obtain a plurality of micro-lenses (22) each of which is coupled with micrometric precision at least with regard to the positioning with respect an individual point of emission (19) of said organic led light source (11).

12. Method as in claim 11, **characterized in that** the molding is performed with nickel molds on which the impressions corresponding to the lenticular optical matrix are obtained with the step and repeat technique.

13. Method as in claim 11 or 12, **characterized in that** said molding is performed hot.

14. Method as in claim 13, **characterized in that** the hot molding is performed on an industrial scale with the hot-embossing technique.

15. Method as in claim 11 or 12, **characterized in that** said molding is performed cold.

16. Method as in any claim from 11 to 15 inclusive, **characterized in that** the micro-lenses (22) of a same lenticular optical element (21) are all made equal to each other.

17. Method as in any claim from 11 to 15 inclusive, **characterized in that** the micro-lenses (22) of a same lenticular optical element (21) are made different from each other so as to perform specific functions of directing and shaping the light beam emitted by the relative point of light emission (19).

18. Method as in any claim from 11 to 17 inclusive, **characterized in that** said molding takes place after said substrate (20) has been associated with the light source (11).

19. Method as in any claim from 11 to 17 inclusive, **characterized in that** said molding takes place before the light source (11) has been associated with said substrate (20).

20. Method as in any claim from 11 to 19 inclusive, **characterized in that** the micro-lenses (22) of said lenticular optical element (21) are positioned shifted with respect to the corresponding crossing point, or pixel, (19) between a positive electrode (14) and a negative electrode (13).

## Patentansprüche

1. Leuchtanordnung, welche ein zumindest teilweise transparentes Substrat (20) und eine Lichtquelle (11), welche an einer ersten Fläche von dem Substrat (20) angegliedert ist, enthält, wobei die Lichtquelle (11) zumindest eine positive Elektrode (14) und eine negative Elektrode (13) zur Zufuhr von einer elektrischen Leistung enthält, welche miteinander zusammenwirken und zwischen denen zumindest eine Lumineszenzschicht von einem Organic-LED-Typ (OLED) (16, 17) positioniert ist, wobei das Substrat (20) dazu in der Lage ist, das Licht, welches durch die Organic-LED-Lumineszenzschicht (16, 17), erzeugt ist, zu zerstreuen, wobei ein linsenförmiges Optikelement (21) an der gegenüberliegenden Fläche von dem Substrat (20) angegliedert ist, dass das linsenförmige Optikelement (21) zum Zerstreuen des Lichtstrahls, welcher durch die Lichtquelle (11) emittiert wird, eine Mehrzahl von Mikrolinsen (22) enthält, welche mittels einer zuvor geformten Gießform auf einer zweiten Fläche von dem Substrat (20), gegenüberliegend zu der ersten Fläche, direkt gegossen sind, um somit mit der Organic-LED-Lichtquelle (11) einen integrierten Aufbau zu bilden, um das Licht zu erzeugen, zu emittieren und auszurichten, wobei jede von den Mikrolinsen (22) mit einem Relativpunkt von einer Lichtemission (19) von der Lichtquelle (11) gekoppelt ist, um den emittieren Relativ-Lichtstrahl auszurichten und zu formen, **dadurch gekennzeichnet, dass** die Mikrolinsen (22) eine Relativmitte haben, welche mit Bezug auf den Relativpunkt von der Lichtemission (19) verschoben positioniert ist.

2. Anordnung nach Anspruch 1, **dadurch gekennzeichnet, dass** jeder von den Punkten der Lichtemission (19) Kreuzpunkte (19) oder Pixel zwischen der positiven Elektrode (14) und der negativen Elektrode (13) enthält.

3. Anordnung nach Anspruch 1, **dadurch gekennzeichnet, dass** die Verschiebung mit Bezug auf die eine und/oder die andere von den Hauptachsen (x, y) von der Relativ-Mikrolinse (22) erzielt ist.

4. Anordnung nach einem der vorherigen Ansprüche, **dadurch gekennzeichnet, dass** zumindest einige von den Mikrolinsen (22) vom Beugungstyp sind, um den Lichtstrahl, welcher durch den Relativpunkt von der Lichtemission (19) emittiert ist, abzulenken und auszurichten.

5. Anordnung nach einem der vorherigen Ansprüche, **dadurch gekennzeichnet, dass** die Mikrolinsen (22) eine Dicke zwischen 1 und 100 Mikrometer ( 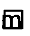 ), vorzugsweise zwischen 1 und 40 Mikrometer haben.

6. Anordnung nach einem der vorherigen Ansprüche, **dadurch gekennzeichnet, dass** die Mikrolinsen (22) eine Flächengröße zwischen 5 und 1000 Mikrometer, vorzugsweise zwischen 10 und 300 Mikrometer haben.

7. Anordnung nach einem der vorherigen Ansprüche, **dadurch gekennzeichnet, dass** die Mikrolinsen (22) von einem Relativ-Linsenform-Optikelement (21) zueinander alle gleich sind.

8. Anordnung nach einem der Ansprüche 1 bis 6, **dadurch gekennzeichnet, dass** die Mikrolinsen (22) von einem Relativ-Linsenform-Optikelement (21) zueinander unterschiedlich sind, um den Lichtstrahl, welcher durch den Relativpunkt von der Lichtemission (19) emittiert ist, auszurichten und zu formen.

9. Anordnung nach einem der Ansprüche 1 bis 8, **dadurch gekennzeichnet, dass** das Substrat (20) aus einem Kunststoffmaterial erstellt ist.

10. Anordnung nach einem der Ansprüche 1 bis 8, **dadurch gekennzeichnet, dass** das Substrat (20) aus einem zumindest teilweise flexiblen Glas erstellt ist.

11. Verfahren zum Herstellen von Leuchtanordnungen, welche zumindest eine Organic-LED-Typ-Mehrfachschicht-Lichtquelle (11) und zumindest ein Optiksystem (12) zum Zerstreuen und Ausrichten der Lichtstrahlen enthalten, welche zumindest ein zumindest teilweise transparentes Substrat (20), zumindest ein linsenförmiges Optikelement (21), welches mit einer Fläche von dem Substrat (20), gegenüberliegend zu der Fläche, an welcher die Lichtquelle (11) bereitgestellt ist, verbunden ist, **dadurch gekennzeichnet, dass** das linsenförmige Optikelement (21) mittels einer vorgeformten Gießform direkt auf das Substrat (20) gegossen ist, um eine Mehrzahl von Mikrolinsen (22) zu erlangen, wobei jede davon mit einer Mikrometer-Genauigkeit, zumindest in Bezug auf die Positionierung in Bezug auf einen Individual-Emissionspunkt (19) von der Organic-LED-Lichtquelle (11) gekoppelt ist.

12. Verfahren nach Anspruch 11, **dadurch gekennzeichnet, dass** der Guss mit Nickel-Gussmaterialien, auf welchen die Prägungen entsprechend der linsenförmigen Optik-Matrix mit einer Schritt- und Wiederholtechnik erlangt werden, durchgeführt wird.

13. Verfahren nach Anspruch 11 oder 12, **dadurch gekennzeichnet, dass** der Guss unter Wärme durchgeführt wird.

14. Verfahren nach Anspruch 13, **dadurch gekennzeichnet, dass** der Wärmeguss im industriellen Maßstab mit einer Wärmeprägungstechnik durchgeführt wird.

15. Verfahren nach Anspruch 11 oder 12, **dadurch gekennzeichnet, dass** der Guss kalt durchgeführt wird.

16. Verfahren nach einem der Ansprüche 11 bis 15, **dadurch gekennzeichnet, dass** die Mikrolinsen (22) eines gleichen linsenförmigen Optikelements (21) alle zueinander gleich erstellt werden.

17. Verfahren nach einem der Ansprüche 11 bis 15, **dadurch gekennzeichnet, dass** die Mikrolinsen (22) von einem gleichen linsenförmigen Optikelement (21) zueinander unterschiedlich erstellt werden, um somit spezifische Funktionen zum Ausrichten und Formen des Lichtstrahls durchzuführen, welcher durch den Relativpunkt von der Lichtemission (19) emittiert wird.

18. Verfahren nach einem der Ansprüche 11 bis 17, **dadurch gekennzeichnet, dass** der Guss stattfindet, nachdem das Substrat (20) mit der Lichtquelle (11) verbunden wurde.

19. Verfahren nach einem der Ansprüche 11 bis 17, **dadurch gekennzeichnet, dass** der Guss vor dem Verbinden von der Lichtquelle (11) mit dem Substrat (20) stattfindet.

20. Verfahren nach einem der Ansprüche 11 bis 19, **dadurch gekennzeichnet, dass** die Mikrolinsen (22) von dem linsenförmigen Optikelement (21) mit Bezug auf den entsprechenden Kreuzpunkt oder einem Pixel (19) zwischen einer positiven Elektrode (14) und einer negativen Elektrode (13) verschoben positioniert werden.

## Revendications

1. Dispositif d'éclairage comprenant un substrat au moins partiellement transparent (20) et une source de lumière (11) rendus solidaires sur une première face dudit substrat (20), ladite source de lumière (11) incluant au moins une électrode positive (14) et une électrode négative (13) pour fournir du courant électrique, qui interagissent l'une avec l'autre et entre lesquelles au moins une couche luminescente du type led organique (OLED) (16, 17) est située, ledit substrat (20) étant capable de diffuser la lumière générée par ladite couche luminescente de led organique (16, 17), un élément optique lenticulaire (21) étant associé sur la face opposée dudit substrat (20), ledit élément optique lenticulaire (21) diffuse le faisceau lumineux émis par ladite source de lumière (11) comprenant une pluralité de microlentilles (22) moulées directement, au moyen d'un moule préformé, sur une seconde face dudit substrat (20), opposée à la première face de façon à constituer avec ladite source de lumière led organique (11), une structure intégrée pour générer, émettre et orienter la lumière, chacune desdites microlentilles (22) étant couplée avec un point relatif de l'émission de lumière (19) de ladite source de lumière (11) afin d'orienter et de donner une forme au faisceau de lumière émis relatif,
**caractérisé en ce que** lesdites microlentilles (22) ont le centre relatif situé en décalage par rapport au point relatif de l'émission de lumière (19).

2. Dispositif selon la revendication 1, **caractérisé en ce que** chacun desdits points d'émission de lumière (19) consiste en des points de croisement (19), ou pixels, entre ladite électrode positive (14) et ladite électrode négative (13).

3. Dispositif selon la revendication 1, **caractérisé en ce que** ledit décalage est obtenu par rapport à l'un et/ou à l'autre des axes principaux (x, y) des microlentilles relatives (22).

4. Dispositif selon l'une quelconque des revendications mentionnées ci-dessus, **caractérisé en ce que** au moins certaines desdites microlentilles (22) sont de type à diffraction afin de dévier et d'orienter le rayon de lumière émis par le point relatif de l'émission de lumière (19).

5. Dispositif selon l'une quelconque des revendications mentionnées ci-dessus, **caractérisé en ce que** lesdites microlentilles (22) ont une épaisseur comprise entre 1 et 100 microns (µm), de préférence entre 1 et 40 microns.

6. Dispositif selon l'une quelconque des revendications précédentes **caractérisé en ce que** lesdites microlentilles (22) ont une taille latérale comprise entre 5 et 1 000 microns, de préférence entre 10 et 300 microns.

7. Dispositif selon l'une quelconque des revendications mentionnées ci-dessus, **caractérisé en ce que** les microlentilles (22) d'un élément optique lenticulaire relatif (21) sont toutes égales les unes aux autres.

8. Dispositif selon l'une quelconque des revendications 1 à 6 incluses, **caractérisé en ce que** les microlentilles (22) d'un élément optique lenticulaire relatif (21) sont différentes les unes des autres afin d'orienter et donner une forme au faisceau lumineux émis par le point relatif de l'émission de lumière (19).

9. Dispositif selon l'une quelconque des revendications 1 à 8 incluses, **caractérisé en ce que** ledit substrat (20) est constitué de matière plastique.

10. Dispositif selon l'une quelconque des revendications 1 à 8 incluses, **caractérisé en ce que** ledit substrat (20) est constitué de verre au moins partiellement élastique.

11. Procédé de fabrication de dispositif d'éclairage comprenant au moins une source de lumière multicouche du type led organique (11) et au moins un système optique (12) pour diffuser et orienter les faisceaux lumineux, comprenant au moins un substrat au moins partiellement transparent (20), au moins un élément optique lenticulaire (21) étant associé à une phase dudit substrat (20) sur le côté opposé à la face où ladite source de lumière (11) est fournie, **caractérisé en ce que** ledit élément optique lenticulaire (21) est directement moulé, au moyen d'un moule préformé sur ledit substrat (20) afin d'obtenir une pluralité de microlentilles (22) dont chacune est couplée avec une précision micrométrique au moins en ce qui concerne le positionnement par rapport à un point individuel d'émission (19) de ladite source de lumière par led organique (11).

12. Procédé selon la revendication 11, **caractérisé en ce que** le moulage est effectué avec des moules en nickel sur lesquels des impressions correspondant à la matrice optique lenticulaire sont obtenues grâce à la technique pas à pas.

13. Procédé selon la revendication 11 ou 12, **caractérisé en ce que** ledit moulage est effectué à chaud.

14. Procédé selon la revendication 13, **caractérisé en ce que** le moulage à chaud est effectué à l'échelle industrielle avec la technique de gaufrage à chaud.

15. Procédé selon la revendication 11 ou 12, **caractérisé en ce que** ledit moulage est effectué à froid.

16. Procédé selon l'une quelconque des revendications 11 à 15 incluses, **caractérisé en ce que** les microlentilles (22) d'un même élément optique lenticulaire (21) sont toutes égales les unes avec les autres.

17. Procédé selon l'une quelconque des revendications 11 à 15 incluses, **caractérisé en ce que** les microlentilles (22) d'un même élément optique lenticulaire (21) sont différentes les unes des autres de façon à effectuer des fonctions spécifiques d'orientation et de formage du faisceau de lumière émis par le point relatif d'émission de lumière (19).

18. Procédé selon l'une quelconque des revendications 11 à 17 incluses **caractérisé en ce que** ledit moulage a lieu après que ledit substrat (20) a été associé avec la source de lumière (11).

19. Procédé selon l'une quelconque des revendications 11 à 17 incluses, **caractérisé en ce que** ledit moulage a lieu avant que ladite source de lumière (11) ait été associée avec ledit substrat (20).

20. Procédé selon l'une quelconque des revendications 11 à 19 incluses, **caractérisé en ce que** les microlentilles (22) dudit élément optique lenticulaire (21) sont positionnées en décalage par rapport au point d'intersection correspondant au pixel (19) entre une électrode positive (14) et une électrode négative (13).
